Europäisches Patentamt

European Patent Office

Office européen des brevets

(19)

(11) Veröffentlichungsnummer: **0 360 916**

**A1**

(12) **EUROPÄISCHE PATENTANMELDUNG**

(21) Anmeldenummer: **88116232.5**

(22) Anmeldetag: **30.09.88**

(51) Int. Cl.5 **H03H 11/24**

(43) Veröffentlichungstag der Anmeldung:
**04.04.90 Patentblatt 90/14**

(84) Benannte Vertragsstaaten:
**DE FR GB IT**

(71) Anmelder: **Siemens Aktiengesellschaft
Wittelsbacherplatz 2
D-8000 München 2(DE)**

(72) Erfinder: **Meier, Wolfgang, Dipl.-Ing.
Balanstrasse 69
D-8000 München 90(DE)**
Erfinder: **Huber, Jakob, Dipl.-Phys.
Flurweg 35
D-8201 Beyharting(DE)**

(54) Monolithisch integrierbares Mirkowellen-Dämpfungsglied.

(57) Bei einem monolithisch integrierbaren Mikrowellen-Dämpfungsglied soll die Dämpfung zwischen verschiedenen diskreten Werten umschaltbar sein und soll beim Umschalten zwischen den einzelnen Dämpfungswerten das Signal nur einen kleinen Phasensprung erfahren. Drain-Source-Strecken von Feldeffekttransistoren (Q1, Q2, Q3) sind in Pi-Konfiguration angeordnet. Zu den Drain-Source- Strecken der in Pi-Konfiguration angeordneten Feldeffekttransistoren (Q1, Q2, Q3) sind Widerstände (R11, R22, R33) parallel geschaltet.

EP 0 360 916 A1

## Monolithisch integrierbares Mikrowellendämpfungsglied.

Die Erfindung betrifft ein monolithisch integrierbares Mikrowellendämpfungsglied nach dem Oberbegriff des Anspruchs 1.

In vielen Geräten der Mikrowellentechnik werden Schaltungen benötigt, die es ermöglichen, Dämpfungen bzw. Verstärkungen zwischen verschiedenen diskreten Werten umzuschalten. Häufig wird von solchen Schaltungen auch verlangt, daß beim Umschalten zwischen den einzelnen Dämpfungs- bzw. Verstärkungswerten das Signal nur einen möglichst kleinen Phasensprung erfährt (IEEE Transactions on Microwave Theory and Techniques, Vol.MTT-23, No.6, June 1975, pages 461-469).

Weitere Gesichtspunkte bei der Bewertung solcher Schaltungen sind zusätzlich die Baugröße, die erreichbare Schaltgeschwindigkeit, der Leistungsverbrauch, welcher zur Umschaltung benötigt wird, der Schaltungsaufwand, welcher zur Ansteuerung der Umschalter notwendig ist, die Hochfrequenz-Bandbreite, in welcher die spezifizierten Werte gelten, die Anpassung der Schaltung in den verschiedenen Zuständen, und die Genauigkeit, mit welcher sich die verschiedenen Dämpfungs- bzw. Verstärkungs-Zustände einstellen lassen.

Umschaltbare Mikrowellendämpfungsglieder bestanden in der Vergangenheit entweder aus voluminösen mechanischen/elektromechanischen Umschaltern oder aus elektrisch schaltbaren PIN-Dioden-Dämpfungsgliedern (IEEE Transactions on Microwave Theory and Techniques, Vol.MTT-28, No.7. July 1980, pages 774-776) oder aus aktiven Elementen (Feldeffekt-Transistoren), bei denen durch die Wahl bestimmter Arbeitspunkte verschiedene Dämpfungs- bzw. Verstärkungs- zustände eingestellt werden können (Microwave Journal, Nov.1982, pages 61-74). Elektromechansich einstellbare Dämpfungsglieder sind durch ein großes Volumen, sehr kleine Schaltgeschwindigkeiten und große Schaltleistungen gekennzeichnet. Schaltbare PIN-Dioden-Dämpfungsglieder besitzen zwar im allgemeinen eine sehr große Schaltgeschwindigkeit, sie benötigen jedoch große Schaltleistungen, lassen sich nicht in einfacher Weise monolithisch integrieren und nehmen auch im Hybridaufbau relativ viel Platz in Anspruch. Sowohl die mechanisch/elektromechanischen Dämpfungsglieder als auch die bekannten PIN-Dioden-Dämpfungsglieder werden durch direkte Einstellung der hochfrequenzmäßig wirksamen Widerstände abgeglichen, was den Abgleich aufwendig gestaltet.

Die Einstellung bestimmter Verstärkungs- bzw. Dämpfungs-Werte durch die Wahl entsprechender Arbeitspunkte bei aktiven Elementen kann zwar relativ schnell und leistungsarm erfolgen, jedoch ist bei solchen Schaltungen am Eingang und am Ausgang jeweils ein umfangreiches Anpassungsnetzwerk erforderlich, das die nutzbare Bandbreite erheblich einschränkt und den Platzbedarf erhöht. Weil die Umsetzung des Steuersignals in den diesem Steuersignal entsprechenden Dämpfungszustand über die individuelle Kennlinie des aktiven Elements erfolgt, ist bei solchen Konzepten ein umfangreicher Abgleich erforderlich. Außerdem sind bei aktiven Elementen Verstärkungs- bzw. Dämpfungs-Änderungen im allgemeinen mit einer relativ großen Änderung der Signalphase verbunden.

Bisher bekannte Schaltungen mit Feldeffekttransistoren in Pi-Anordnung (Firmenschrift "Success in Microwaves", herausgegeben von der Firma Plessey Research,(Caswell)Ltd. England) benutzen keine zu den Drain-Source-Strecken parallel geschaltete Widerstände. Bei Anordnungen, die die Pi-Topologie nur mit Feldeffekttransistoren erzeugen, tritt bei den großen exemplarabhängigen Toleranzen der Kanalwiderstände bei einer bestimmten Steuerspannung das Problem eines komplizierten sukzessiven Abgleichs der Feldeffekttransistoren-Steuerspannung auf.

Der vorliegenden Erfindung liegt die Aufgabe zugrunde, ein monolithisch integrierbares Mikrowellendämpfungsglied der eingangs genannten Art anzugeben, bei dem die Dämpfung zwischen verschiedenen diskreten Werten umschaltbar ist und bei dem beim Umschalten zwischen den einzelnen Dämpfungswerten das Signal nur einen kleinen Phasensprung erfährt.

Diese Aufgabe wird erfindungsgemäß durch ein monolithisch integrierbares Mikrowellendämpfungsglied nach dem Anspruch 1 gelöst.

Das Mikrowellendämpfungsglied nach der Erfindung ist mindestens zwischen zwei Dämpfungszuständen umschaltbar. Ein Mikrowellendämpfungsglied nach der Erfindung ist vorteilhaft als monolithisch integrierte Schaltung ausgeführt. Vorzugsweise sind dabei GaAs-Feldeffekttransistoren verwendet. Vorteilhafterweise werden Dünnschicht- bzw. Implantationswiderstände verwendet.

Ein Mikrowellendämpfungsglied nach der Erfindung ermöglicht das Lösen der oben genannten Probleme in einfacher Weise. Infolge der gewählten Anordnung der einzelnen Bauelemente ist der Phasensprung zwischen zwei Dämpfungszuständen sehr klein. Dieser Phasensprung beträgt typischerweise einige Grad im X-Band. Eine monolithische Integration ermöglicht eine sehr kleine Baugröße. Die erreichbare Schaltgeschwindigkeit ist sehr hoch. Die Schaltzeit kann auf maximal 10ns begrenzt werden. Bei einem Mikrowellendämpfungsglied nach der Erfindung wird nur eine sehr geringe Steuerleistung benötigt. Die Ansteuerung kann über einen einfachen Pegelumsetzer mit Hilfe üblicher Logikschaltungen erfolgen.

Infolge der Struktur der Schaltung und infolge entsprechend gewählter Schaltelemente-Werte werden große Bandbreiten und gute Anpassung in den mindestens zwei Dämpfungszuständen ermöglicht.

Außerdem arbeitet die Schaltung bidirektioal. Weil in mindestens einem Dämpfungszustand nur der Serien-Feldeffekttransistor (Q3) als steuerbarer Widerstand wirkt und die Parallel-Feldeffekttransistoren Q1 und Q2 vollständig sperren bzw. weil in minde stens einem Dämpfungszustand die Parallel-Feldeffekttransistoren Q1 und Q2 als steuerbare Widerstände wirken und der Serien- Feldeffekttransistor Q3 vollständig sperrt und weil die zu den sperrenden Feldeffekttransistoren parallel geschalteten Widerstände zusammen mit den leitenden Feldeffekttransistoren und deren Parallelwiderständen das Pi-Glied bilden, läßt sich über die DC-Steuerspannung der aktiven Feldeffekttransistoren ein einfacher und für die Dämpfungszustände unabhängiger Abgleich auf den gewünschten Dämpfungswert des jeweiligen Dämpfungszustandes erreichen. Da die Dämpfungsglieder gemäß dieser Erfindung am Eingang und Ausgang bezüglich des Wellenwiderstands angepaßt sind, lassen sich mit Mikrowellendämpfungsgliedern nach der Erfindung leicht Dämpfungsglieder-Ketten mit z.B. binär gestaffelten Einzeldämpfungen aufbauen. Durch die Kombination eines Verstärkers mit einem Mikrowellendämpfungsglied nach dieser Erfindung lassen sich Verstärker mit umschaltbarer Verstärkung in einfacher Weise aufbauen.

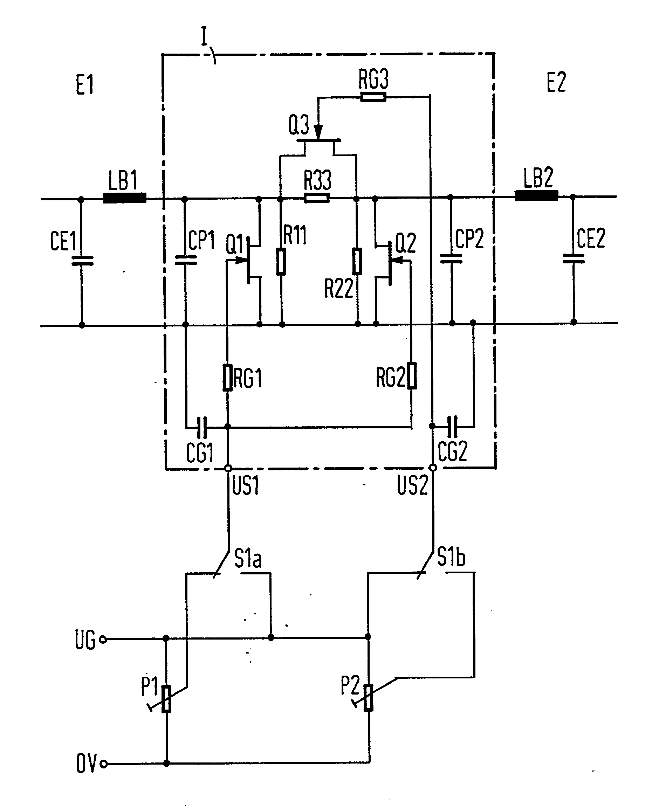

Ausgestaltungen und Vorteile der Erfindung sind in den Unteransprüchen, der Beschreibung und der Zeichnung dargestellt.

Die Erfindung wird im folgenden anhand der Zeichnung näher erläutert.

Die Figur zeigt ein Mikrowellen-Dämpfungsglied nach der Erfindung.

Das Mikrowellen-Dämpfungsglied nach der Figur ist vorzugsweise als integrierte Schaltung I ausgebildet. Das Mikrowellen-Dämpfungsgleid nach der Figur besteht aus Feldeffekttransistoren, Widerständen und Kapazitäten, zwei Anschlußtoren für den Signalpfad sowie zwei Steuerspannungsanschlüssen. Die Drain-Source- Strecken der verwendeten Feldeffekttransistoren Q1, Q2, Q3 sind in einer Pi-Konfiguration angeordnet. Zu den Drain-Source-Strekten der Feldeffekttransistoren sind Widerstände R11, R22, R33 parallel geschaltet. Der Widerstand R33 ist wegen der erwünschten Genauigkeit als Dünnfilmwiderstand ausgeführt. Die Widerstände R11, R22 sind wegen der geringeren Toleranzanforderungen in einer einfachen Technologie z.B. als Implantations-Widerstände zusammen mit den Kanälen der Feldeffekttransistoren hergestellt.

Das Mikrowellendämpfungsglied nach der Figur sei zunächst nur zwischen zwei Dämpfungszuständen umschaltbar. Zum Ermöglichen eines leichten Abgleichs der Dämpfungen in den zwei Dämpfungszuständen werden jeweils die Parallel-Feldeffekttransistoren Q1, Q2 bzw. der Serien-Feldeffekttransistor Q3 durch eine geeignete Steuerspannung vollständig gesperrt. Nur die Steuerspannung der in dem jeweiligen Dämpfungszustand jeweils leitenden Feldeffekttransistoren wird zum Ausgleich der Dämpfung benutzt.

Das Mikrowellendämpfungsglied nach der Figur besteht aus einer Pi-Anordnung der Widerstände R11, R22, R33 und der Feldeffekttransistoren Q1, Q2, Q3. Die Feldeffekttransistoren Q1, Q2, Q3 arbeiten als steuerbare Widerstände im Anlaufbereich (im ohmschen Bereich) der Ausgangskennlinie, das heißt, daß über die Steuerspannungsanschlüsse US1 und US2 die Widerstände der Drain-Source-Strecken der Feldeffekttransistoren Q1, Q2, Q3 verändert werden. Die Gate-Widerstände RG1, RG2, RG3 zusammen mit den Kondensatoren CG1, CG2 dienen zur Entkopplung der DC-Steuersignale von den Hochfrequenz-Signalen an den Source- bzw. Drain- Elektroden der Feldeffekttransistoren Q1, Q2, Q3. Zusammen mit den Bondinduktivitäten LB1, LB2 und den externen Kapazitäten CE1, CE2 dienen die chip-internen Kapazitäten CP1, CP2 zur Anpassung an den Wellenwiderstand des äußeren Systems E1, E2.

Durch die gewählte Anordnung der Widerstände R11, R22, R33, die bei monolithischer Integration des Mikrowellendämpfungsgliedes als Dünnfilm- bzw. Implantationswiderstände ausgeführt werden können, läßt sich ein Abgleich der Schaltung auf die gewünschten Dämpfungswerte einfach erreichen.

Für den Zustand hoher Dämpfung wird dem Serien-Feldeffekttransistor Q3 eine Gate-Spannung US2 in einer solchen Höhe zugeführt, daß seine Drain-Source-Strecke mit Sicherheit hochohmig wird. Im Längszweig der Pi-Anordnung wirkt dann nur der zur Drain- Source-Strecke des Feldeffekttransistors Q3 parallelgeschaltete Widerstand R33. Die Transistoren Q1, Q2 werden über den einstellbaren Widerstand P1 mit einer Gate-Spannung US1 so versorgt, daß ihre Kanäle leitend werden. Durch Abgleich des einstellbaren Widerstands P1 können die Widerstände der Drain-Source-Strekten der Parallel-Feldeffekttransistoren Q1, Q2 so eingestellt werden, daß sich in der Parallelschaltung mit den Widerständen R11 und R22 die richtige Widerstandskombination für ein reflexionsfreies Dämpfungsglied mit einer bestimmten Dämpfung ergibt.

Im Zustand niedriger Dämpfung erhalten die Drain-Source-Strecken der Parallel-Feldeffekttransistoren Q1, Q2 die Gate-Spannung UG, so daß ihre Drain-Source-Strecken sperren. Durch Abgleich des einstellbaren Widerstands P2 kann über die Steuerspannung des Serien-Feldeffekttransistors Q3 der Drain-Source-Widerstand des Feldeffekttransistors Q3 so eingestellt werden, daß sich durch die Parallelschaltung mit dem Widerstand R33 der richtige Widerstandswert einer Pi-Schaltung mit den Querwiderständen R11, R22 ergibt.

Vorteilhaft ist, daß sich durch die gewählte Anordnung von Widerständen R11, R22, R33 parallel zu den Drain-Source-Strecken der in Pi-Struktur angeordneten Feldeffekttransistoren die Dämpfungswerte in den beiden Dämpfungszuständen unabhängig voneinander einstellen lassen. Bekannte Anordnung von in Pi-Struktur angeordneten Feldeffekttransistoren besitzen keine Parallelwiderstände und erfordern daher einen schwierigen sukzessiven Abgleich.

Bei der Verwendung von monolithisch integrierten Mikrowellen- Schaltungen besteht das Problem, eine wellenwiderstandsgerechte Verbindung dieser integrierten Schaltung zur äußeren Schaltungsumgebung E1, E2 herzustellen. Die für diese Verbindung häufig genutzten Bonddrähte besitzen in dem für das erfindungsgemäße Mikrowellen-Dämpfungsglied infragekommenden Frequenzbereich eine nicht zu vernachlässigende Induktivität, die zu Fehlanpassungen führt. Durch die Parallel-Schaltung der Kapazitäten CP1, CP2 zu den Eingangsklemmen des erfindungsgemäßen Mikrowellen-Dämpfungsglieds I wird erreicht, daß die wellenwiderstandsgerechte Verbindung des Dämpfungsglieds I mit der Schaltungsumgebung E1, E2 in einfacher Weise möglich ist.

Die sich auf dem Chip I befindenden Kondensatoren CP1, CP2, die als MIM(Metall-Isolator-Metall)- oder Interdigital-Kondensatoren ausgeführt sein können, bilden zusammen mit den Bondinduktivitäten LB1, LB2 und kleinen externen Kapaazitäten CE1, CE2 eine Pi- Leitungsnachbildung des geforderten Wellenwiderstands. Dadurch wird erreicht, daß die normalerweise als parasitäre Elemente vorhandenen Bondverbindungen in vorteilhafter Weise mit in die Schaltung einbezogen werden können. Die Kapazitäten CE1, CE2 können nicht in Form von Leitungsverbreiterungen der Streifenleitungen (Striplines) realisiert werden. Wenn die Kapazitäten CP1, CP2 so gewählt werden, daß sie groß gegenüber den parasitären Kapazitäten der normalerweise kleinen Transistorsysteme Q1, Q2 sind, wird eine Anpassung unabhängig vom Schaltzustand der Feldeffekttransistoren erreicht.

Durch die Einbeziehung der Bondinduktivitäten in eine Leitungsnachbildung wird eine gute Anpassung über einen Frequenzbereich von typischerweise größer als eine Oktave im Mikrowellengebiet erreicht. In diesem Frequenzbereich sind die Dämpfungen aufgrund der hauptsächlich resistiven Wirkungsweise des Dämpfungsglieds nahezu konstant, und der Phasensprung des Signals beim Umschalten der Dämpfungszustände bleibt klein.

In Parallelschaltung zu den Signaltoren ist jeweils ein Kondensator CP1, CP2 mitintegriert, der zusammen mit den Induktivitäten LB1, LB2 der Zuleitungen zum Chip I und externen Kapazitäten CE1, CE2 eine Leitungsnachbildung aus konzentrierten Elementen bildet und so den störenden Einfluß der Zuleitungsinduktivität beseitigt.

Die Kondensatoren der Leitungsnachbildung sind so groß gewählt, daß demgegenüber der Einfluß der Kapazitäten der Feldeffekttransistoren und anderer parasitärer Kapazitäten gering ist und so eine Anpassung in beiden Dämpfungszuständen erreicht wird.

Vorteilhafterweise wird der über andere Kapazitäten überwiegende Einfluß der Kapazitäten CP1, CP2 parallel zu den Signaltoren der Schaltung dazu benutzt, den Phasensprung der Signalphase beim Umschalten zwischen den Dämpfungszuständen zu minimieren.

Vorteilhafterweise kann die Steuerspannung US1, US2 an den Gates der Feldeffekttransistoren Q1 und Q2 bzw. Q3 im Betriebsfall mehr als zwei Werte annehmen. Auf diese Weise können mit einem einzigen Mikrowellen-Dämpfungsglied mehr als zwei Dämpfungszustände realisiert werden.

Die Widerstände R11, R22, R33 parallel zu den Drain-Source- Strecken der Feldeffekttransistoren Q1, Q2, Q3 dienen in diesem Fall der Spreizung der Steuerkennlinien.

Bei Realisierung des Mikrowellendämpfungsgliedes als monolithische integrierte Mokrowellen-Schaltung I benötigt das Dämpfungsglied nur sehr wenig Raum.

Da beim Umschalten der Dämpfungszustände nur die kleinen Gate- Kapazitäten der Feldeffekttransistoren Q1, Q2, Q3 umgeladen werden müssen, läßt sich trotz der hohen Vorwiderstände eine große Schaltgeschwindigkeit erreichen. Außerdem ist als Ansteuerleistung nur die zum Umladen der Gate-Kapazitäten bei einer bestimmten Frequenz notwendige Leistung aufzubringen. Da die Feldeffekttransistoren Q1, Q2, Q3 als steuerbare Widerstände betrieben werden, also quasi passive Bauelemente darstellen, kann die Schaltung bidirektional betrieben werden.

Die Steuerspannungen US1, US2 werden über die Schalter S1a, S1b dem Mikrowellendämpfungsglied I zugeführt.

**Ansprüche**

1. Monolithisch integrierbares Mikrowellendämpfungsglied, das Feldeffekttransistoren (Q1, Q2, Q3) aufweist, welche in Pi- Struktur angeordnet sind, mit Anschlußtoren für den Signalpfad und mit Steuerungsanschlüssen, **dadurch gekennzeichnet,** daß die Drain-Source-Strecken der Feldeffekttransistoren (Q1, Q2, Q3) in Pi-Konfiguration angeordnet sind, und daß zu den Drain-Source-Strecken der in Pi-Konfiguration angeordneten Feldeffekttransistoren (Q1, Q2, Q3) Widerstände (R11, R22, R33) parallel geschaltet sind.

2. Mikrowellendämpfungsglied nach Anspruch 1, **dadurch gekennzeichnet,** daß der zu der Drain-Source- Strecke des Serien-Feldeffekttransistors (Q3) parallel geschaltete Widerstand (R33) als Dünnfilmwiderstand ausgebildet ist.

3. Mikrowellendämpfungsglied nach Anspruch 1 oder 2, **dadurch gekennzeichnet,** daß die zu den Drain-Source-Strecken der Parallel-Feldeffekttransistoren (Q1, Q2) parallel geschalteten Widerstände (R11, R22) als Implantationswiderstände ausgebildet sind.

4. Mikrowellendämpfungsglied nach einem der Ansprüche 1 bis 3, **dadurch gekennzeichnet,** daß der in der Pi-Konfiguration angeordnete Serien-Feldeffekttransistor (Q3) durch eine geeignete Steuerspannung vollständig sperrbar ist.

5. Mikrowellendämpfungsglied nach einem der Ansprüche 1 bis 3, **dadurch gekennzeichnet,** daß die in der Pi-Konfiguration angeordneten Parallel-Feldeffekttransitoren (Q1, Q2) durch eine geeignete Steuerspannung vollständig sperrbar sind.

6. Mikrowellendämpfungsglied nach einem der Ansprüche 1 bis 5, **dadurch gekennzeichnet,** daß in Parallelschaltung zu den Signaltoren jeweils ein Kondensator (CP1, CP2) vorhanden ist, der zusammen mit den Induktivitäten (LB1, LB2) der Zuleitungen und externen Kapazitäten (CE1, CE2) eine Leitungsnachbildung aus konzentrierten Elementen bildet.

7. Mikrowellendämpfungsglied nach Anspruch 6, **dadurch gekennzeichnet,** daß die Kapazitäten der Kondensatoren der Leitungsnachbildung so groß sind, daß demgegenüber der Einfluß der Kapazitäten der Feldeffekttransistoren (Q1, Q2, Q3) und anderer parasitärer Kapazitäten gering ist.

8. Mikrowellendämpfungsglied nach einem der Ansprüche 1 bis 7, **dadurch gekennzeichnet,** daß die Steuerspannungen der Feldeffekttransistoren (Q1, Q2, Q3) mehr als zwei Werte annehmen können.

EP 0 360 916 A1

**Europäisches Patentamt**

# EUROPÄISCHER RECHERCHENBERICHT

Nummer der Anmeldung

EP 88 11 6232

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| Y | 1982 IEEE MTT-S INTERNATIONAL MICROWAVE SYMPOSIUM DIGEST, Dallas, Texas, 15. - 17. Juni 1982, Seiten 479-481, IEEE; Y. TAJIMA et al.: "GaAs monolithic wideband (2-18 GHz) variable attenuators" <br> * Figur 1; Seiten 479-480: "Attenuator design" * <br> --- | 1,2 | H 03 H 11/24 |
| Y | FR-A-1 402 015 (RADIO CORPORATION OF AMERICA) <br> * Figur 7; Seite 6, linke Spalte, Zeilen 1-44 * <br> --- | 1,2 | |
| A | EP-A-0 148 706 (THOMSON) <br> * Insgesamt * <br> ----- | 1 | |
| | | | **RECHERCHIERTE SACHGEBIETE (Int. Cl.3)** |
| | | | H 03 H |

Der vorliegende Recherchenbericht wurde für alle Patentansprüche erstellt

| Recherchenort | Abschlußdatum der Recherche | Prüfer |
|---|---|---|
| DEN HAAG | 30-05-1989 | COPPIETERS C. |